# EUROPEAN PATENT SPECIFICATION

(11) **EP 0 233 734 B1**
(45) Date of publication and mention of the grant of the patent: **15.09.1993**
(21) Application number: 87301049.0
(22) Date of filing: 05.02.1987
(51) Int. Cl.: H03K 5/02, H03K 19/017

(54) **Clock signal generating circuit**
Generatorschaltung zur Taktsignalerzeugung
Circuit générateur de signaux d'horloge

(30) Priority: 08.02.1986 JP 24955/86
(43) Date of publication of application: 26.08.1987
(73) Proprietor: FUJITSU LIMITED, Kawasaki-shi, Kanagawa 211 (JP)
(72) Inventor: Takemae Yoshihiro, Minato-ku Tokyo 107 (JP)
(74) Representative: Fane, Christopher Robin King

(56) References cited:
- EP-A- 0 032 017
- EP-A- 0 052 504
- EP-A- 0 098 060
- EP-A- 0 109 004
- GB-A- 2 156 617
- US-A- 4 352 996
- US-A- 4 521 701

## Description

The present invention relates to clock signal generating circuitry.

In the field of the semiconductor large scale integrated (LSI) circuit, the clock signal generating circuit (or clock generator) is widely used for synchronous operations among a central processing unit, memories and interface units. Accordingly, it is necessary to generate clock signals having a precise timing from the clock generator in order to carry out these synchronous operations. Moreover, the operating speed of these units depends on the clock rate (i.e. clock generating speed from the clock generator). Particularly, the logic operations of the LSI circuit greatly depend on this clock rate.

Therefore, it is necessary to realise extremely precise, high speed, and highly reliable clock signals.

According to a first aspect of the present invention, there is provided clock signal generating circuitry, for use in a semiconductor large scale integrated circuit, comprising: a first channel-type transistor, of P-channel conductivity type, and a second channel-type transistor, of the opposite channel conductivity type, which transistors have respective current paths connected together in series, at a common output node of the circuitry, between a positive-side power supply line and a ground-side power supply line, a gate of the said first channel-type transistor being connected to receive a first input clock signal, and an output clock signal of the circuitry being produced at the said common output node; a third channel-type transistor, of the said opposite channel conductivity type, having a current path connected between the said common output node and a gate of the said second channel-type transistor, and having a gate connected to receive a second input clock signal; and a bootstrap capacitor having a first electrode connected to the said common output node and a second electrode connected to receive a third input clock signal; characterised by a further capacitor connected between the said gate of the said second channel-type transistor and the said gate of the said first channel-type transistor.

EP-A-0098060 proposes clock signal generating circuitry comprising: an N-channel transistor and a first P-channel transistor, which transistors have respective current paths connected together in series, at a common output node of the circuitry, between a first power supply line and a second power supply line, a gate of the said N-channel transistor being connected to receive a first input clock signal, and an output clock signal of the circuitry being produced at the said common output node; a second P-channel transistor having a current path connected between the said common output node and a gate of the said first P-channel transistor, and having a gate connected to receive a second input clock signal; and a bootstrap capacitor having a first electrode connected to the said common output node and a second electrode connected to receive a third input clock signal.

According to a second aspect of the present invention, there is provided clock signal generating circuitry, for use in a semiconductor large scale integrated circuit, comprising: a first channel-type transistor, of P-channel conductivity type, and a second channel-type transistor, of the opposite channel conductivity type, which transistors have respective current paths connected together in series, at a common node of the circuitry, between a positive-side power supply line and a further node of the circuitry; a third channel-type transistor, of the said opposite channel conductivity type, having a current path connected between the said further node and a ground-side power supply line; and a bootstrap capacitor having a first electrode connected to the said further node and a second electrode connected to receive an input clock signal; characterised by a fourth channel-type transistor, of the said opposite channel conductivity type, having a current path connected between the said further node and a gate of the said third channel-type transistor, and having a gate connected to receive another input clock signal, and by a further capacitor having a first electrode connected to the said gate of the said third channel-type transistor and a second electrode connected to receive a further input clock signal, respective gates of the said first and second channel-type transistors being connected to receive yet another input clock signal, and an output clock signal of the circuitry being produced at the said common node.

GB-A-2156617 proposes clock signal generating circuitry comprising: a P-channel transistor and a first N-channel transistor, which transistors have respective current paths connected together in series, at a common node of the circuitry, between a first power supply line and a further node of the circuitry; a second N-channel transistor having a current path connected between the said further node and a second power supply line; and a bootstrap capacitor having a first electrode connected to the said further node and a second electrode connected to receive an input clock signal.

Reference will now be made, by way of example, to the accompanying drawings, in which:
Fig. 1 is a circuit diagram of conventional clock signal generating circuitry;
Fig. 2 is a signal timing chart of the circuitry shown in Fig. 1;
Fig. 3. is a circuit diagram of clock signal generating circuitry according to a first aspect of the present invention;
Fig. 4 is a signal timing chart of the circuit shown in Fig. 3;
Fig. 5 is a circuit diagram of clock signal generating circuitry according to a second aspect of the present invention; and
Fig. 6 is a signal timing chart of the circuit shown in Fig. 5.

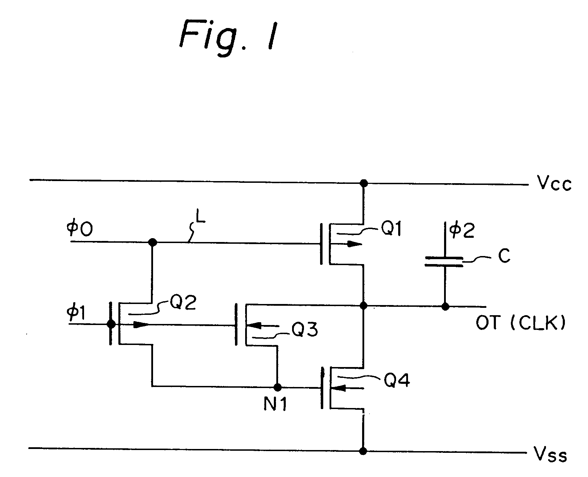

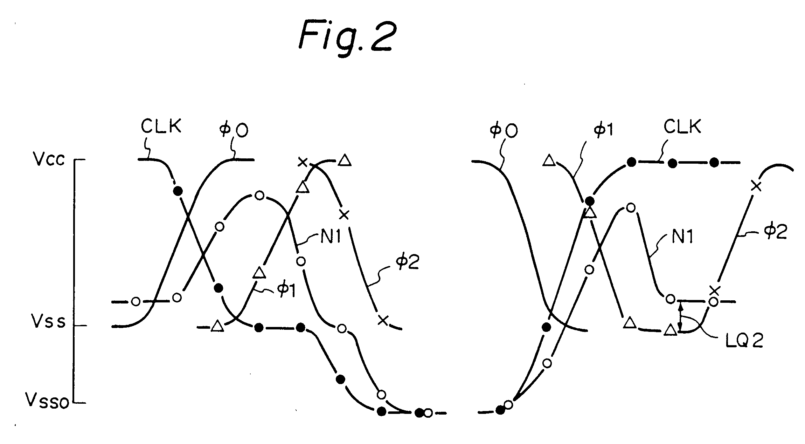

Firstly, with reference to Figs. 1 and 2, an explanation will be given of clock signal generating circuitry based on that proposed in EP-A-0098060.

Referring to Fig. 1, Q1 to Q4 denote MOS transistors, C a bootstrap capacitor, Φ0 to Φ2 input clock signals, OT an output terminal, N1 a node, V_{cc} a voltage level of a positive side power source line, and Vₛₛ a voltage level of a ground side power source line.

The operations of this circuit will be explained in detail with reference to Fig. 2.

In Fig. 2, the left side denotes an active state and the right side denotes a reset state. The clock signal CLK is obtained by alternately repeating these two states. The clock signal CLK is produced at the output terminal OT, and is indicated in Fig. 2 by black dots.

The clock signal CLK is pulled down from the V_{cc} level to a Vₛₛ₀ level, which is lower than the Vₛₛ level, by a bootstrap effect of the capacitor C in the active state and pulled up from the Vₛₛ₀ level to the V_{cc} level in the reset state. In order to obtain these curves, first, when the clock signal Φ0 applied to the gate of the transistor Q1 is pulled up from the Vₛₛ level to the V_{cc} level, the P-channel transistor Q1 is turned OFF. Accordingly, the level of the output terminal OT is held to the V_{cc} level.

At this time, the clock signal Φ1 applied to the gate of the transistor Q2 is set to the Vₛₛ level, and thus the P-channel transistor Q2 is held in the ON state. Accordingly, the node N1 is charged up through the transistor Q2 so as to approach the V_{cc} level.

When the node N1 approaches the V_{cc} level, the level of the output terminal OT reaches the Vₛₛ level, since the N-channel transistor Q4 is turned ON. Next, when the clock signal Φ1 is pulled up from the Vₛₛ level to the V_{cc} level, the P-channel transistor Q2 is turned OFF and the N-channel transistor Q3 is turned ON. Accordingly, the charge of the node N1 is discharged through the transistor Q3 to the output terminal OT. Thus, the level of the node N1 is pulled down to the Vₛₛ level, and then the N-channel transistor Q4 is turned OFF.

In these states, when the clock signal Φ2 is pulled down from the V_{cc} level to the Vₛₛ level, the level of the output terminal OT is pulled down to the Vₛₛ₀ level lower than the Vₛₛ level. This rapid pulling down of the output level depends on the so-called bootstrap effect achieved by the bootstrap capacitor C.

That is, when the node N1 is at the Vₛₛ level, the charges flow from the Vₛₛ side to the output terminal OT when the level of the output terminal OT is pulled down to the Vₛₛ - Vₜₕ level. Accordingly, the level of the output terminal OT cannot be pulled down lower than the above level. In this case, since the N-channel transistor Q3 is turned ON and the node N1 is connected to the output terminal OT, the level of the node N1 can be simultaneously pulled down and the transistor Q4 is held in the OFF state. Accordingly, the level of the output terminal OT can be pulled down to the Vₛₛ₀ level lower than the Vₛₛ level of the ground side power source line. This phenomenon is known as the bootstrap effect.

When the node N1 is the Vₛₛ level, the level of the output terminal OT is pulled down to the Vₛₛ - Vₜₕ and the charges flow from the Vₛₛ side as explained above. This phenomenon will be explained in more detail below. That is, when the node N1 is the Vₛₛ level, the output side of the transistor Q4 becomes a source and the ground side thereof becomes a drain, when the output terminal OT is pulled down lower than the Vₛₛ level. When the source side of the transistor Q4 becomes Vₛₛ - Vₜₕ , the potential difference between the source and the drain becomes higher than Vₜₕ. Accordingly, the charges (current) flow from the ground side to the output terminal side. In this case, although the level of the output terminal OT is not pulled down lower than the level of Vₛₛ - Vₜₕ , in actual practice, the level of the output terminal OT is pulled down to the Vₛₛ₀ level since the transistor Q3 is turned ON and the transistor Q4 is turned OFF. As a result, the bootstrap effect is realized in the output terminal OT.

In the reset state, when the clock signal Φ0 is pulled down from the V_{cc} level to the Vₛₛ level, the P-channel transistor Q1 is turned ON and the clock signal CLK is pulled up to the V_{cc} level. At this time, since the clock signal Φ1 is held at the V_{cc} level, the transistor Q2 is held in the OFF state and the transistor Q3 is held in the ON state. Accordingly, the node N1 is charged up through the transistor Q3 so as to approach the V_{cc} level.

Next, when the clock signal Φ1 is also pulled down from the V_{cc} level to the Vₛₛ level, the transistor Q3 is turned OFF and the transistor Q2 is turned ON. Accordingly, the charge of the node N1 is discharged to the signal line L of the clock signal Φ0 through the transistor Q2 and the level of the node N1 is pulled down so as to approach the Vₛₛ level. Thus, the N-channel transistor Q4 is turned OFF.

There is, however, a problem in the reset state. That is, when the transistor Q2 is turned ON, the charge of the node N1 is discharged to the signal line L. Accordingly, the level of the node N1 is pulled down to nearly the level of the Vₛₛ level as shown in Fig. 2. The difference between this level and the Vₛₛ level is shown by "LQ2" in Fig. 2. The difference LQ2 is caused by a threshold level Vₜₕ of the transistor Q2.

Accordingly, assuming that the threshold level of the P-channel transistor Q2 is higher than that of the N-channel transistor Q4, the level of the node N1 cannot be pulled down to a sufficiently low level (i.e. Vₛₛ level), and thus the N-channel transistor cannot be completely turned OFF.

Consequently, it is difficult to obtain an extremely precise, high speed, and highly reliable clock signal CLK in the conventional clock generator.

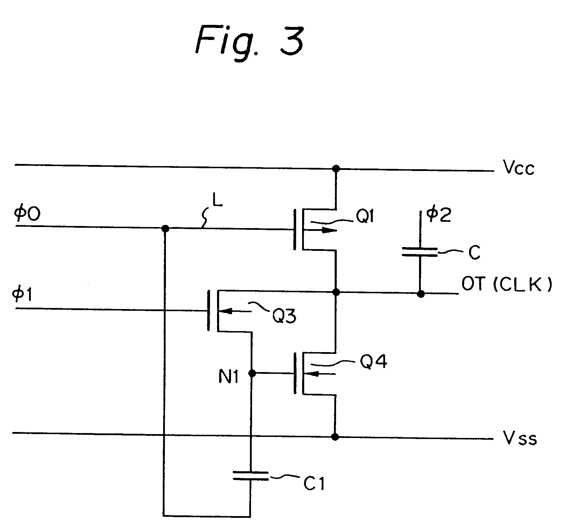

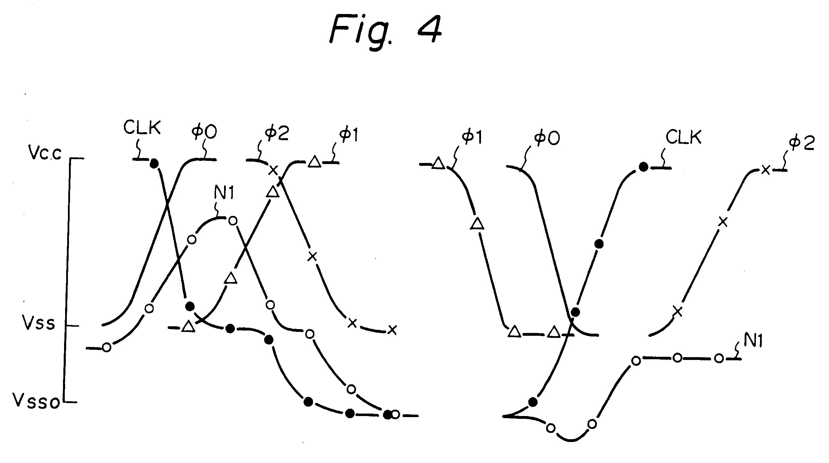

A clock signal generating circuit embodying the first aspect of the present invention will be explained in detail hereinafter with reference to Figs. 3 and 4.

Referring to Fig. 3, the same reference numbers are attached to the same components as that of the circuit shown in Fig. 1. In this embodiment, the P-channel transistor Q2 is omitted and a capacitor C1 is added between the node N1 and the signal line L.

The operations of this circuit will be explained in detail with reference to Fig. 4.

In Fig. 4, when the clock signal Φ0 applied to the gate of the transistor Q1 is pulled up from the Vₛₛ level to the V_{cc} level, the P-channel transistor Q1 is turned OFF and the level of the output terminal OT (clock signal CLK is output) is held to the V_{cc} level. At this time, the level of the node N1 is pulled up by the capacitor C1 so as to approach the V_{cc} level.

When the level of the node N1 is pulled up, the level of the clock signal CLK is pulled down to the Vₛₛ level since the first N-channel transistor Q4 is turned ON. Next, when the clock signal Φ1 applied to the gate of the transistor Q3 is pulled up from the Vₛₛ level to the V_{cc} level, the second N-channel transistor Q3 is turned ON. Accordingly, the charge of the node N1 is discharged through the transistor Q3 to the output terminal OT, then, the node N1 is pulled down to the Vₛₛ level, and thus the N-channel transistor Q4 is turned OFF.

In these states, when the clock signal Φ2 applied to the bootstrap capacitor C is pulled down from the V_{cc} level to the Vₛₛ level, the level of the clock signal CLK is pulled down to the Vₛₛ₀ level lower than the Vₛₛ level by the bootstrap effect of the capacitor C.

In the reset state, when the clock signal Φ1 is pulled down from the V_{cc} level to the Vₛₛ level, the N-channel transistor Q3 is turned OFF. When the clock signal Φ0 is pulled down from the V_{cc} level to the Vₛₛ level, the P-channel transistor Q1 is turned ON. Accordingly, the clock signal CLK is pulled up to the V_{cc} level and the level of the node N1 is pulled down further.

As explained above, the N-channel transistor Q3 is turned OFF when the clock signal Φ1 is pulled down from the V_{cc} level to the Vₛₛ level. The clock signal CLK is pulled up from the Vₛₛ₀ level to the V_{cc} level when the, clock signal Φ0 is pulled down from the V_{cc} level to the Vₛₛ level. Accordingly, the node N1 is charged up through the transistor Q3. When the threshold level of the transistor Q3 is Vₜₕ , the level of the node N1 becomes Vₛₛ - Vₜₕ. Consequently, it is possible for the transistor Q4 to completely turn OFF since the level of the node N1 is sufficiently pulled down. As explained in Figs. 1 and 2, conventionally, the level of the node N1 becomes Vₛₛ + Vₜₕ. Therefore, it is difficult for the transistor Q4 to completely turn OFF since the level of the node N1 can not be sufficiently pulled down.

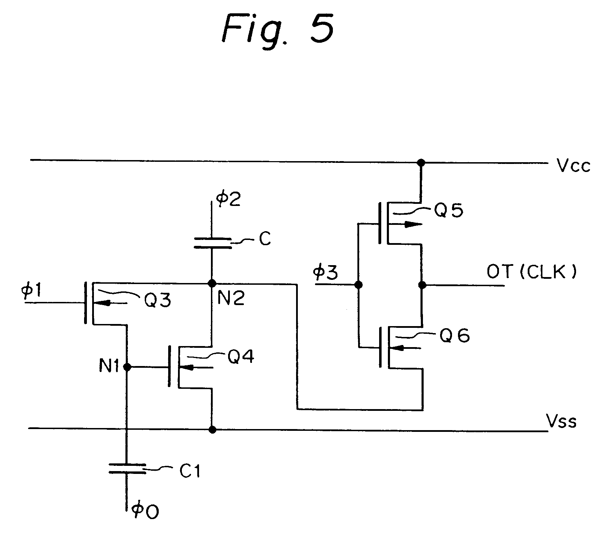

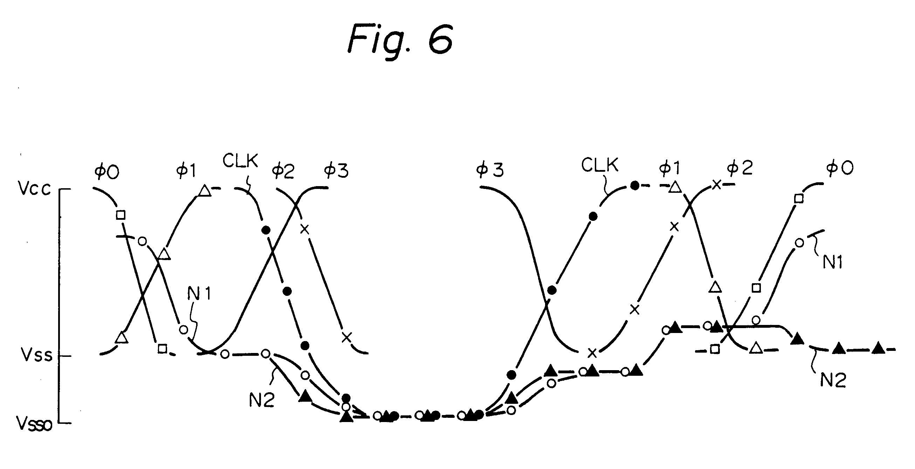

Clock signal generating circuitry embodying the second aspect of the present invention will now be explained with reference to Figs. 5 and 6.

Referring to Fig. 5, the P-channel transistor Q5 and the first N-channel transistor Q6 are newly added to the output stage. Accordingly, the output terminal OT is provided at the common connection point of both transistors Q5 and Q6. The clock signal Φ3 is also newly applied to the common connection point of both gates of the transistors Q5 and Q6. Each of the transistors Q5 and Q6 is constituted by a complementary MOS transistor (CMOS transistor).

In the active state, when the clock Signal Φ0 is pulled down from the V_{cc} level to the Vₛₛ level, the level of the first node N1 is pulled down from the near level of the V_{cc} level to the Vₛₛ level and the second N-channel transistor Q4 is turned OFF. At this time, when the clock signal Φ1 is pulled up from the Vₛₛ level to the V_{cc} level, the third N-channel transistor Q3 is turned ON, then, the node N1 is connected to the second node N2. In this state, when the clock signal Φ3 is pulled up from the Vₛₛ level to the V_{cc} level, the P-channel transistor Q5 is turned OFF and the N-channel transistor Q6 is turned ON, thus, the clock signal CLK is pulled down from the V_{cc} level to the Vₛₛ₀ level. At this time, when the clock signal Φ2 is pulled down from the V_{cc} level to the Vₛₛ level, the level of the node N2 is pulled down lower than the Vₛₛ level by the bootstrap effect of the capacitor C. Since the node N2 is pulled down lower than the Vₛₛ level at the same time as the transistor Q6 is turned ON, the clock signal CLK is rapidly pulled down from the V_{cc} level to the Vₛₛ₀ level lower than the Vₛₛ level by the bootstrap effect of the capacitor C.

In the reset state, when the clock signal Φ3 is pulled down from the V_{cc} level to the Vₛₛ level, the P-channel transistor Q5 is turned ON and the N-channel transistor Q6 is turned OFF. Accordingly, the level of the output terminal OT (clock signal CLK is output) is pulled up from the Vₛₛ₀ level to the V_{cc} level. At this time, the charge of the node N2 is slightly discharged to the output terminal.

In this state, when the clock signal Φ2 is pulled up from the Vₛₛ level to the V_{cc} level, the levels of the nodes N1 and N2 are pulled up to Vₛₛ + Vₜₕ since the node N1 is connected to the node N2 through the transistor Q3. This value Vₛₛ + Vₜₕ is a limitation value at which the transistor Q4 is not turned ON. Next, when the clock signal Φ1 is pulled down from the V_{cc} level to the Vₛₛ level, the N-channel transistor Q3 is turned OFF. After this step, when the clock signal Φ0 is pulled up from the Vₛₛ level to the V_{cc} level, the level of the node N1 is pulled up and the N-channel transistor Q4 is turned ON. Accordingly, the level of the node N2 is held at the Vₛₛ level.

In the specification, all of the clock signals Φ0, Φ1, Φ2 and Φ3 are generated from control means (not shown) in the LSI circuit, and since a conventional control means can be used, an explanation thereof will be omitted.

## Claims

1. Clock signal generating circuitry, for use in a semiconductor large scale integrated circuit, comprising:
a first channel-type transistor (Q₁), of P-channel conductivity type, and a second channel-type transistor (Q₄), of the opposite channel conductivity type, which transistors (Q₁, Q₄) have respective current paths connected together in series, at a common output node (OT) of the circuitry, between a positive-side power supply line (V_{CC}) and a ground-side power supply line (V_{SS}), a gate of the said first channel-type transistor (Q₁) being connected to receive a first input clock signal (Φ₀), and an output clock signal (CLK) of the circuitry being produced at the said common output node (OT);
a third channel-type transistor (Q₃), of the said opposite channel conductivity-type, having a current path connected between the said common output node (OT) and a gate of the said second channel-type transistor (Q₄), and having a gate connected to receive a second input clock signal (Φ₁); and
a bootstrap capacitor (C) having a first electrode connected to the said common output node (OT) and a second electrode connected to receive a third input clock signal (Φ₂);
characterised by a further capacitor (C₁) connected between the said gate of the said second channel-type transistor (Q₄) and the said gate of the said first channel-type transistor (Q₁).

2. Clock signal generating circuitry, for use in a semiconductor large scale integrated circuit, comprising:
a first channel-type transistor (Q₅), of P-channel conductivity type, and a second channel-type transistor (Q₆), of the opposite channel conductivity type, which transistors (Q₅, Q₆) have respective current paths connected together in series, at a common node (OT) of the circuitry, between a positive-side power supply line (V_{CC}) and a further node (N₂) of the circuitry;
a third channel-type transistor (Q₄), of the said opposite channel conductivity type, having a current path connected between the said further node (N₂) and a ground-side power supply line (V_{SS}); and
a bootstrap capacitor (C) having a first electrode connected to the said further node (N₂) and a second electrode connected to receive an input clock signal (Φ₂);
characterised by a fourth channel-type transistor (Q₃), of the said opposite channel conductivity type, having a current path connected between the said further node (N₂) and a gate of the said third channel-type transistor (Q₄), and having a gate connected to receive another input clock signal (Φ₁), and by a further capacitor (C₁) having a first electrode connected to the said gate of the said third channel-type transistor (Q₄) and a second electrode connected to receive a further input clock signal (Φ₀), respective gates of the said first and second channel-type transistors (Q₅, Q₆) being connected to receive yet another input clock signal (Φ₃), and an output clock signal (CLK) of the circuitry being produced at the said common node (OT).

## Patentansprüche

1. Schaltungsaufbau zum Erzeugen von Taktsignalen, zur Verwendung in einer Halbleiter-Großintegrationsschaltung, mit:
einem ersten Kanal-Typ-Transistor (Q₁), vom p-Kanal-Leitfähigkeitstyp, und einem zweiten Kanal-Typ-Transistor (Q₄), vom entgegengesetzten Kanal-Leitfähigkeitstyp, welche Transistoren (Q₁, Q₄) entsprechende Stromwege aufweisen, die, an einem gemeinsamen Ausgangsknoten (OT) des Schaltungsaufbaus, zwischen einer Energiezufuhrleitung (V_{CC}) an der positiven Seite und einer Energiezufuhrleitung (V_{SS}) an der Erdeseite in Serie miteinander verbunden sind, wobei ein Gate des genannten ersten Kanal-Typ-Transistors (Q₁) angeschlossen ist, um ein ersten Eingangstaktsignal (Φ₀) zu empfangen, und wobei ein Ausgangstaktsignal (CLK) des Schaltungsaufbaus am genannten gemeinsamen Ausgangsknoten (OT) erzeugt wird;
einem dritten Kanal-Typ-Transistor (Q₃), vom genannten entgegengesetzten Kanal-Leitfähigkeitstyp, welcher einen Stromweg aufweist, der zwischen dem genannten gemeinsamen Ausgangsknoten (OT) und einem Gate des zweiten Kanal-Typ-Transistors (Q₄) angeschlossen ist, und welcher ein Gate hat, das angeschlossen ist, um ein zweites Eingangstaktsignal (Φ₁) zu empfangen; und
einem Bootstrap-Kondensator (C), der eine erste Elektrode, die mit dem genannten gemeinsamen Ausgangsknoten (OT) verbunden ist, und eine zweite Elektrode aufweist, die angeschlossen ist, um ein drittes Eingangstaktsignal (Φ₂) zu empfangen;
gekennzeichnet durch einen weiteren Kondensator (C₁), der zwischen dem genannten Gate des genannten zweiten Kanal-Typ-Transistors (Q₄) und dem genannten Gate des genannten ersten Kanal-Typ-Transistors (Q₁) angeschlossen ist.

2. Schaltungsaufbau zum Erzeugen von Taktsignalen, zur Verwendung in einer Halbleiter-Großintegrationsschaltung, mit:
einem ersten Kanal-Typ-Transistor (Q₅), vom p-Kanal-Leitfähigkeitstyp, und einem zweiten Kanal-Typ-Transistor (Q₆), vom entgegengesetzten Kanal-Leitfähigkeitstyp, welche Transistoren (Q₅, Q₆) entsprechende Stromwege aufweisen, die, an einem gemeinsamen Ausgangsknoten (OT) des Schaltungsaufbaus, zwischen einer Energiezufuhrleitung (V_{CC}) an der positiven Seite und einem weiteren Knoten (N₂) des Schaltungsaufbaus in Serie miteinander verbunden sind;
einem dritten Kanal-Typ-Transistor (Q₄), vom genannten entgegengesetzten Kanal-Leitfähigkeitstyp, welcher einen Stromweg aufweist, der zwischen dem genannten weiteren Knoten (N₂) und einer Energiezufuhrleitung (V_{SS}) an der Erdeseite angeschlossen ist; und
einem Bootstrap-Kondensator (C), der eine erste Elektrode, die mit dem genannten weiteren Knoten (N₂) verbunden ist, und eine zweite Elektrode aufweist, die angeschlossen ist, um ein Eingangstaktsignal (Φ₂) zu empfangen;
gekennzeichnet durch einen vierten Kanal-Typ-Transistor (Q₃), vom genannten entgegengesetzten Leitfähigkeitstyp, welcher einen Stromweg aufweist, der zwischen dem genannten weiteren Knoten (N₂) und einem Gate des genannten dritten Kanal-Typ-Transistors (Q₄) angeschlossen ist, und welcher ein Gate aufweist, das angeschlossen ist, um ein weiteres Eingangstaktsignal (Φ₁) zu empfangen, und durch einen weiteren Kondensator (C₁), der eine erste Elektrode, die mit dem genannten Gate des genannten dritten Kanal-Typ-Transistors (Q₄) verbunden ist, und eine zweite Elektrode aufweist, die angeschlossen ist, um ein weiteres Eingangstaktsignal (Φ₀) zu empfangen, wobei entsprechende Gates des ersten und des zweiten Kanal-Typ-Transistors (Q₅, Q₆) angeschlossen sind, um noch ein weiteres Eingangstaktsignal (Φ₃) zu empfangen, und wobei ein Ausgangstaktsignal (CLK) des Schaltungsaufbaus am genannten gemeinsamen Knoten (OT) erzeugt wird.

## Revendications

1. Circuit de génération de signaux d'horloge destiné à une utilisation dans un circuit à semiconducteur à grande échelle d'intégration, comprenant :
un premier transistor de type à canal (Q₁) d'un type de conductivité de canal P et un second transistor de type à canal (Q₄) du type de conductivité de canal opposé, lesquels transistors (Q₁, Q₄) comportent des voies de courant respectives connectées ensemble en série, au niveau d'un noeud de sortie commun (OT) du circuit, entre une ligne d'alimentation de côté positif (V_{cc}) et une ligne d'alimentation de côté de masse (Vₛₛ), une grille dudit premier transistor de type à canal (Q₁) étant connectée pour recevoir un premier signal d'horloge d'entrée (Φ₀) et un signal d'horloge de sortie (CLK) du circuit étant produit au niveau dudit noeud de sortie commun (OT) ;
un troisième transistor de type à canal (Q₃) dudit type de conductivité de canal opposé comportant une voie de courant connectée entre ledit noeud de sortie commun (OT) et une grille dudit second transistor de type à canal (Q₄) et comportant une grille connectée pour recevoir un second signal d'horloge d'entrée (Φ₁) ; et
une capacité d'amorçage (C) comportant une première électrode connectée audit premier noeud de sortie commun (OT) et une seconde électrode connectée pour recevoir un troisième signal d'horloge d'entrée (Φ₂),
caractérisé par une autre capacité (C₁) connectée entre ladite grille dudit second transistor de type à canal (Q₄) et ladite grille dudit premier transistor de type à canal (Q₁).

2. Circuit de génération de signaux d'horloge destiné à une utilisation dans un circuit à semiconducteur à grande échelle d'intégration, comprenant :
un premier transistor de type à canal (Q₅) d'un type de conductivité de canal P et un second transistor de type à canal (Q₆) du type de conductivité de canal opposé, lesquels transistors (Q₅, Q₆) comportent des voies de courant respectives connectées ensemble en série, au niveau d'un noeud commun (OT) du circuit, entre une ligne d'alimentation de côté positif (V_{cc}) et un autre noeud (N₂) du circuit ;
un troisième transistor de type à canal (Q₄) dudit type de conductivité de canal opposé comportant une voie de courant connectée entre ledit autre noeud (N₂) et une ligne d'alimentation de côté de masse (Vₛₛ) ; et
une capacité d'amorçage (c) comportant une première électrode connectée audit autre noeud (N₂) et une seconde électrode connectée pour recevoir un signal d'horloge d'entrée (Φ₂),
caractérisé par un quatrième transistor de type à canal (Q₃) dudit type de conductivité de canal opposé comportant une voie de courant connectée entre ledit autre noeud (N₂) et une grille dudit troisième transistor de type à canal (Q₄) et comportant une grille connectée pour recevoir un autre signal d'horloge d'entrée (Φ₁), et par une autre capacité (C₁) comportant une première électrode connectée à ladite grille dudit troisième transistor de type à canal (Q₄) et une seconde électrode connectée pour recevoir un autre signal d'horloge d'entrée (Φ₀), des grilles respectives desdits premier et second transistors de type à canal (Q₅, Q₆) étant connectées pour recevoir encore un autre signal d'horloge d'entrée (Φ₃) et un signal d'horloge de sortie (CLK) du circuit étant produit au niveau dudit noeud commun (OT).
